Europäisches Patentamt

European Patent Office

Office européen des brevets

(19)

(11) **EP 0 742 616 B1**

(12) **FASCICULE DE BREVET EUROPEEN**

(45) Date de publication et mention
de la délivrance du brevet:
**08.08.2001 Bulletin 2001/32**

(51) Int Cl.⁷: **H01S 3/06**, H01S 3/094

(21) Numéro de dépôt: **96401015.1**

(22) Date de dépôt: **10.05.1996**

(54) **Emetteur infrarouge monolithique à semi-conducteur pompé par un microlaser solide déclenché**

Monolitische Halbleiterinfrarotsender, optisch gepumpt durch einen gütegeschalteten Festkörpermikrolaser

Monolithic semiconductor infrared emitter optically pumped by a solid state Q-switched microlaser

(84) Etats contractants désignés:
**DE GB IT**

(30) Priorité: **12.05.1995 FR 9505655**

(43) Date de publication de la demande:
**13.11.1996 Bulletin 1996/46**

(73) Titulaire: **COMMISSARIAT A L'ENERGIE ATOMIQUE**
**75015 Paris (FR)**

(72) Inventeurs:
• **Molva, Engin**
**38000 Grenoble (FR)**
• **Pautrat, Jean-Louis**
**38100 Grenoble (FR)**

(74) Mandataire: **Moutard, Pascal Jean et al**
**c/o Brevatome,**
**25, rue de Ponthieu**
**75008 Paris (FR)**

(56) Documents cités:
EP-A- 0 432 009       EP-A- 0 523 861
EP-A- 0 588 327       WO-A-90/09688
US-A- 4 982 405       US-A- 5 048 051
US-A- 5 394 413

• IEEE JOURNAL OF QUANTUM ELECTRONICS, vol. qe-18, no. 4, Avril 1982, NEW YORK US, pages 511-513, XP002009702 J. STONE ET AL: "Tunable InGaAsP lasers for spectral measurements of high bandwidth fibers"
• OPTICS LETTERS, vol. 6, no. 11, Novembre 1981, WASHINGTON US, pages 534-536, XP002009703 J. STONE ET AL: "Optically pumped ultrashort cavity InGaAsP lasers: picosecond operation between 0.83 and 1.59 mum"
• SOVIET JOURNAL OF QUANTUM ELECTRONICS, vol. 14, no. 3, Mars 1984, WOODBURY, NEW YORK US, pages 336-338, XP002009704 A.G. ALEKSANYAN ET AL: "Semiconductor laser made of BiSb"
• OPTICS LETTERS, vol. 10, no. 5, Mai 1985, WASHINGTON US, pages 232-234, XP002009705 C.S. LEE ET AL: "Observation of optical bostability due to resonator configuration transition"

## Description

Domaine technique

Le domaine technique de l'invention est celui des émetteurs de lumière infrarouge, notamment dans la gamme 1-20 µm, de faible puissance, qui peuvent être utilisés pour des applications comme la spectroscopie d'absorption de gaz, la détection de gaz, la détection d'espèces chimiques, la détection de polluants.

Ces émetteurs peuvent être "cohérents" (par exemple une diode laser) ou "incohérents" (par exemple une diode électroluminescente).

Etat de la technique

Les diodes lasers (émission cohérente) et les diodes électroluminescentes (émission incohérente) sont connues et très largement utilisées dans de nombreuses applications. Ces diodes sont réalisées à partir de matériaux semi-conducteurs de type GaAlAs ou GaAsP ou GaInAs ou GaInAsP, etc... Les longueurs d'onde accessibles sont situées entre 0,6 et 1,5 µm.

L'avantage principal de ces structures est la possibilité de pouvoir choisir a priori une longueur d'onde spécifique dans la gamme accessible au matériau. La longueur d'onde d'un émetteur à semi-conducteur peut être choisie continûment dans un domaine assez large, en modifiant soit la composition des alliages, soit les caractéristiques physiques des structures à semi-conducteurs utilisées dans les dispositifs émetteurs de lumière.

Malheureusement les émetteurs à semi-conducteurs qui sont bien connus et maîtrisés émettent dans une gamme de longueur d'onde limitée qui ne dépasse pas 1,5 µm, la longueur d'onde qui peut être émise étant essentiellement déterminée par la largeur de la bande interdite du semi-conducteur.

Or, de nombreuses applications et en particulier celles citées ci-dessus nécessitent des longueurs d'onde au-delà de 1,5 µm, jusqu'à 3, 5, 10 ou 20 µm.

Certains alliages semi-conducteurs, comme par exemple les composés II-VI (CdHgTe), les composés III-V (GaAlAsSb, InAsSb) ou les composés IV-VI (les sels de plomb), ont une largeur de bande qui permet de réaliser des émetteurs de lumière infrarouge dans une gamme de longueurs d'onde intéressante, c'est-à-dire entre 1 et 5 µm, voire même entre 1 et 40 µm.

On peut les faire fonctionner en pompage optique, à l'aide d'un laser de pompe absorbé par le semi-conducteur (laser à semi-conducteur à pompage optique). Ceci permet de s'affranchir des problèmes technologiques liés à la réalisation des structures diodes à injection électrique (problèmes de dopage et de contact électrique qui sont mal maîtrisés dans ces matériaux).

Cependant, les technologies actuelles qui pourraient permettre de réaliser des structures de type diode laser ou diode électroluminescente, afin d'obtenir une émission à une longueur d'onde supérieure à quelques micromètres, sont très mal maîtrisées.

En particulier, ces structures fonctionnent à très basse température.

Par exemple, les diodes lasers à base de sels de plomb ($Pb_xSn_{1-x}Se$, $Pb_xSn_{1-x}Te$, $PbS_{1-x}Se_x$, $Cd_xPb_{1-x}S$) permettent d'obtenir des longueurs d'onde $\lambda > 1$ µm (jusqu'à 40 µm), mais pour une température T<160 K. De même, les alliages du type InAsSb ($InAs_xSb_{1-x}$) sur substrat d'InAs peuvent fonctionner à T<160 K pour donner une émission de longueur d'onde comprise entre 2,9 et 3,6 µm. A ce sujet, on peut se reporter à l'article de H. Preler "Physics and applications of IV-VI compound semiconductor lasers" paru dans Semiconductors Science and Technology, vol. 5, S12-S20 (1990), à celui de N.C. Giles et al. "Stimulated emission at 2.8 µm from Hg-based quantum well structures grown by photoassisted molecular beam epitaxy" paru dans Applied Physics Letters, vol. 55, p. 2026-2028 (1992), à celui de Z. Feit et al. "Single mode molecular beam epitaxy grown PbEuSeTe/PbTe buried-heterostructure diode lasers" paru dans Applied Physics Letters, vol. 58, p. 343-345 (1991) ou à celui de Z. Feit et al. "Low-threshold PbEuSeTe double-heterostructure lasers" paru dans Applied Physics Letters, vol. 55, p. 16 et suivantes. L'article de A. Ravid et al. intitulé "Optically pumped laser oscillation at 2,5 µm of a CdHgTe layer grown by metalorganic chemical vapor deposition" paru dans Applied Physics Letters, vol. 55, p. 2704-2706 (1989) donne une température maximum de fonctionnement de 150 K.

Les composés pouvant fonctionner à température ambiante ne permettent pas d'obtenir des longueurs d'onde supérieures à 3 µm (alliages quaternaires $Ga_{1-x}Al_xAs_ySb_{1-y}$ pour une émission laser entre 1,8 et 2,4 µm). Une longueur d'onde de 2 µm a été obtenue avec un semi-conducteur $Hg_{0,51}Cd_{0,49}Te$, à température ambiante : ceci est décrit dans l'article de J. Bleuse et al. intitulé "Room-temperature laser emission near 2 µm from an optically pumped HgCdTe separate confinement structure" paru dans Journal of Crystal Growth, 117, 1992, p. 1046-1049.

Tous ces articles montrent bien que le problème de la température est une préoccupation constante dans ce domaine, et qu'il n'a pas encore vraiment reçu de solution.

En outre, les structures fonctionnant à plusieurs µm (sels de plomb) sont d'autant plus difficiles à mettre en oeuvre qu'elles nécessitent des seuils et des courants d'injection élevés.

La puissance obtenue avec les structures connues est par ailleurs en général très faible (moins de 1 mW) et les dispositifs incorporant ces structures sont fragiles. Il est donc difficile d'envisager l'application industrielle de ces dispositifs.

L'Article "Tunable InGaAsP Lasers for Spectral Measurements of High Bandwidth Fibers" de l'I.E.E.E. Journal of Quantum Electronics, n° 4, April 82", décrit un ensemble de mesure dont on veut démontrer la capacité à mesurer des caractéristiques de largeur de bande passante d'une fibre optique.

On dispose donc une fibre optique à mode unique entre une partie émetteur et une partie récepteur.

En ce qui concerne les similitudes avec la présente demande de brevet, seule la partie émission est intéressante. Les auteurs ne s'y intéressent que pour expliquer qu'ils émettent grâce à un laser constitué par un film mince de InGaAsP, une impulsion très courte de l'ordre de 43 ps. Ce laser est pompé par un laser de pompage déclenché. Ils indiquent, que pour ne pas surchauffer le film mince, il n'émet, grâce à un système d'extraction à base de cellules de Pockel, qu'à une fréquence de 1 kHz.

Le brevet US-A-5 394 413 de ZAYHOWSKI, décrit un perfectionnement à un laser déclenché décrit par ZHOU dans un Article d'avril 1993 des "Optics Letters".

Dans la partie "arrière plan technologique", l'auteur indique que "des impulsions ayant de fortes puissances crête peuvent être obtenues au moyen de lasers déclenchés. Cependant, la taille des lasers déclenchés conventionnels empêche la production d'impulsions de très courte durée" (colonne 1, lignes 30-35).

Il indique ensuite (colonne 1, lignes 36-42) que des impulsions très courtes peuvent être obtenues avec des lasers à mode bloqué déclenché ou de lasers à mode bloqué amplifié. Il indique que ces deux moyens sont compliqués, volumineux, consommateurs d'énergie et difficiles à régler.

Il se réfère ensuite à un Article dont il est l'un des Auteurs, où il est révélé que des microlasers à cavités couplées déclenchés de façon active peuvent produire des impulsions de moins de 300 ps avec des puissances crête supérieures à 25 kW. Il continue en expliquant que ces lasers déclenchés peuvent encore être améliorés, notamment en ce qui concerne l'électronique de déclenchement qui requiert une grande vitesse, de forts voltages et des consommations élevées. De même, les températures de fonctionnement doivent encore être maintenues dans des tolérances serrées pour ne pas modifier la longueur relative des cavités constituantes.

L'auteur passe ensuite aux microlasers déclenchés de façon passive dont il indique quelques avantages par rapport aux microlasers déclenchés de façon active. Ces avantages conduisent à leur utilisation dans une large gamme d'applications telles que le micro-usinage et la génération non linéaire de fréquence.

Enfin, juste avant le résumé de l'invention, l'auteur donne les performances d'un laser décrit dans un Article de "Optic letters" où il est indiqué que des lasers déclenchés de façon passive ont atteint des durées d'impulsion de 3,5 nanosecondes.

Exposé de l'invention

La présente invention propose un dispositif qui permet d'obtenir une émission cohérente (laser) ou incohérente, à une longueur d'onde spécifique donnée correspondant à une application définie (par exemple la longueur d'onde d'absorption d'un gaz polluant), et qui peut fonctionner à température ambiante.

Plus précisément, l'invention a pour objet un dispositif pour émetteur de lumière infrarouge tel que décrit dans la revendication 1.

L'intérêt du pompage optique du semi-conducteur est qu'il ne nécessite pas la réalisation d'une structure de diode à injection réalisée avec des dopages p et n, des contacts ohmiques et des technologies de gravure. Ceci permet d'utiliser n'importe quel semi-conducteur pour réaliser un émetteur infrarouge sans la difficulté de réalisation d'une diode à injection.

Selon l'invention, un microlaser est utilisé comme source de pompage optique du semi-conducteur. Le microlaser est une source compacte, robuste, intégrable pour réaliser une structure monolithique, qui a suffisamment de puissance pour atteindre le seuil laser de n'importe quel semi-conducteur, même ceux qui ont des seuils très élevés, et ceci quelle que soit la température. On peut, en effet, obtenir en sortie de microlaser plusieurs kW crête sur un diamètre de 20 à 100 μm, soit des densités de puissances de quelques dizaines de mégawatts/cm$^2$. Cette densité de puissance permet de faire laser en pompage optique la plupart des semi-conducteurs connus.

La puissance émise par le semi-conducteur est alors typiquement de l'ordre de plusieurs dizaines de mW.

En outre, un autre problème résolu simultanément par la présente invention est celui de la largeur des impulsions de pompage : une source de pompage qui délivrerait une puissance suffisante, mais avec des impulsions trop larges du point de vue temporel, entraînerait une charge thermique nuisible au fonctionnement du semi-conducteur. Or, du fait d'une faible longueur de cavité ($\lesssim$ 1 mm) des microlasers déclenchés, leurs impulsions sont brèves (typiquement <1 ns ou au plus 5 ns). Ceci permet d'éviter la charge thermique nuisible évoquée ci-dessus.

En même temps cette courte durée d'impulsion est tout à fait compatible avec les durées de vie des états excités des semi-conducteurs, qui sont très courtes (quelques 100 picosecondes à 1 ns).

Enfin, l'utilisation d'un microlaser permet d'atteindre une grande compacité. En effet, un des avantages du microlaser réside dans sa structure en un empilement de multicouches. Le milieu actif laser est constitué par un matériau de faible épaisseur (entre 150 et 1000 μm), et de petites dimensions (quelques mm$^2$), sur lequel des miroirs diélectriques de cavité sont directement déposés. Comme, de plus, le semi-conducteur se présente lui aussi sous forme de lame mince (typiquement environ 500 µm d'épaisseur), le dispositif selon l'invention est donc très compact.

Enfin, le microlaser étant une source robuste, pouvant être facilement intégrée, et fabricable en mode collectif avec les techniques de la microélectronique (donc à faible coût), le dispositif selon l'invention bénéficie de tous ces avantages.

L'élément semi-conducteur peut avoir la forme d'une lame ayant une épaisseur de quelques centaines de micromètres, par exemple inférieure à 500 µm.

Cet élément peut également avoir la forme d'une couche épitaxiée sur un substrat.

Le semi-conducteur peut être choisi parmi les alliages II-VI, III-V ou IV-VI connus, pour émettre à la bonne longueur d'onde.

L'invention est d'application particulièrement intéressante pour des semi-conducteurs dont l'émission se situe entièrement ou au moins en partie à au moins une longueur d'onde supérieure à 3 µm ($\lambda > 3\mu m$) ou à 2 µm ($\lambda \geq 2\mu m$).

On peut par exemple réaliser des structures en $Pb_xSn_{1-x}Se$ ($7 \leq \lambda$ émission $\leq 40$ µm), en $Pb_xSn_{1-x}Te$ (6 µm $\leq \lambda$ émission $\leq 40$ µm), en $PbS_{1-x}Se_x$ (3-8 µm), en $Cd_xPb_{1-x}S$ (1-4 µm) ou en $Cd_xHg_{1-x}Te$ (1-15 µm).

On peut également utiliser toute les structures connues, fonctionnant à température ambiante, et qui émettent dans la gamme 1-3 µm ($In_xGa_{1-x}As$, $CdS_xSe_{1-x}$, etc..).

Selon l'invention, l'élément semi-conducteur est directement fixé sur la face de sortie du microlaser.

Au moins une des faces du semi-conducteur peut être traitée antireflet.

La structure du dispositif à semi-conducteur selon l'invention permet, selon les cas, soit d'émettre un faisceau incohérent (émission de photoluminescence, équivalente à l'émission d'une diode électroluminescente), soit un faisceau laser cohérent.

L'élément semi-conducteur peut donc faire partie d'un laser à semi-conducteur, en particulier d'une cavité d'un laser à semi-conducteur. Ce laser peut être par exemple du type VCSEL (Vertical Cavity Surface Emitting Laser).

Le laser à semi-conducteur peut également être du type à guide d'onde, l'élément semi-conducteur ayant la forme d'une couche déposée sur un substrat. De plus, la couche peut être orientée dans un plan perpendiculaire à la direction du faisceau émis par le microlaser.

Selon un mode particulier de réalisation, la cavité microlaser est déclenchée passivement par un absorbant saturable.

Un autre aspect de l'invention concerne la disposition relative de l'absorbant saturable et du milieu actif, à l'intérieur de la cavité microlaser.

Selon ce mode particulier, l'absorbant saturable peut être déposé sous la forme d'une couche mince, directement sur le matériau actif de la cavité microlaser.

Un des avantages principaux de ce mode particulier de réalisation, est dans la structure de la cavité microlaser (ou du microsystème laser consistant en un microlaser associé à de la microoptique) déclenchée, qui consiste alors en un empilement de couches, permettant de garder la possibilité d'une fabrication collective à bas coût. Cette structure multicouches ne remet pas en cause la simplicité et les procédés de fabrication collective, donc à faible coûts, des microlasers, tels qu'ils ont été développés pour les microlasers continus. Elle permet de réaliser des microlasers déclenchés passivement, monolithiques, autoalignés (sans aucun réglage optique) et indéréglables. Cette structure ne nécessite aucune opération de collage (au contraire des solutions consistant à coller l'absorbant saturable sur un autre élément de la cavité microlaser) ni aucune opération complexe d'alignement (au contraire des solutions consistant à disposer l'absorbant saturable sans aucun contact avec les autres éléments de la cavité microlaser).

Un autre avantage du microlaser par rapport au laser "codopé" (un même milieu contenant à la fois les ions actifs laser et les ions de l'absorbant saturable) est qu'on sépare le milieu actif de l'absorbant saturable, mais qu'on évite le collage des deux milieux tout en gardant une structure monolithique. Ainsi, on peut :

- d'une part régler indépendamment les épaisseurs (pendant le dépôt des couches ou par amincissement mécanique après le dépôt des couches) et les concentrations des ions dans les deux milieux,
- d'autre part, grâce à cette séparation, réaliser des lasers déclenchés où le même ion (par exemple Er) peut être utilisé comme ion actif et comme absorbant saturable, avec des concentrations différentes.

Selon un autre aspect de l'invention, la couche mince peut être composée d'un colorant organique en solution dans un solvant polymère. Selon une variante, la couche mince est susceptible d'avoir été déposée par épitaxie en phase liquide.

La cavité microlaser peut également être déclenchée activement.

Dans le domaine des microlasers, une technique de déclenchement actif est décrite dans l'article de J.J. Zayhowski et al., intitulé "Diode-pumped microchip lasers Electro-Optically Q Switched at high pulse repetition rates", paru dans Optics Letters, vol. 17, N°17, pp. 1201-1203, (1992). Cette technique peut être utilisée dans le cadre de la présente invention.

Dans ce document, le déclenchement est réalisé dans une configuration de deux cavités Fabry-Perot couplées. Le milieu actif laser, de longueur $L_1$, forme, avec un miroir d'entrée et un miroir intermédiaire une première cavité Fabry-Perot. Le matériau déclencheur (matériau électrooptique, $LiTaO_3$), de longueur $L_2$, forme, avec le miroir intermédiaire et le miroir de sortie, une deuxième cavité Fabry-Perot. Le déclenchement se fait en modifiant la longueur optique du matériau déclencheur par une action externe : des électrodes de déclenchement sont placées perpendiculairement à l'axe du faisceau laser, de part et d'autre du matériau déclencheur. Si une tension V est appliquée entre ces électrodes, un champ électrique $E=V/e$, où $e$ est la distance entre les électrodes (ce qui correspond à l'épaisseur du matériau électro-optique) en résulte. L'indice optique $n_2$, et par conséquent la longueur optique $n_2 L_2$, du matériau électro-optique est modifié par l'action du champ $E$. Ceci affecte le couplage des deux cavités Fabry-Pérot et modifie la réflectivité du miroir intermédiaire vu par le milieu laser.

Cependant, cette technique présente des inconvénients.

Tout d'abord, le microlaser décrit dans ce document est fabriqué par un procédé manuel (il met en oeuvre des étapes de collage de morceaux prédécoupés). Ceci impose une limite inférieure pour les dimensions géométriques qui sont au minimum autour de lmm, et en particulier pour la distance entre les deux électrodes. En outre, un autre problème est la nécessité d'atteindre un champ E suffisant pour le déclenchement. Il est en effet nécessaire d'appliquer une tension de l'ordre de 1000 volts entre les deux électrodes, et ceci en un temps très court (moins de 1 nanoseconde) et sur des puces laser d'environ 1 mm$^3$ de volume. Ceci est très difficile à réaliser en pratique et nécessite une électronique sophistiquée incompatible avec la simplicité et le bas coût de production du microlaser.

Afin de résoudre ce problème, et selon un mode particulier de réalisation de l'invention, le milieu actif laser forme une première cavité résonnante entre un miroir d'entrée et un miroir intermédiaire, un second matériau forme une seconde cavité résonnante entre le miroir intermédiaire et un miroir de sortie, l'indice optique de ce matériau étant apte à être modulé par une perturbation extérieure, et des moyens de réduction de la taille du faisceau laser sont disposés en entrée de la première cavité résonnante, l'ensemble des deux cavités et des moyens de réduction du faisceau laser étant monolithique.

Ainsi, selon ce mode particulier de réalisation, l'invention résout le problème de la tension élevée à appliquer entre les électrodes tout en permettant de diminuer le seuil de la cavité microlaser. En effet, avec cette structure, il est possible de ramener l'épaisseur du second matériau à environ 100μm. Ceci permet, dans le cas d'un matériau électrooptique de limiter la tension nécessaire à une valeur comprise entre 50 et 100 volts. Par ailleurs, le seuil de déclenchement du microlaser se trouve réduit à environ quelques milliwatts. Enfin, cette structure est compatible avec des procédés de fabrication collectifs qui permettent à la fois de fabriquer des échantillons de petite taille et de respecter les coûts de fabrication.

Les moyens de réduction de la taille du faisceau laser peuvent être constitués par un miroir concave réalisé avec un micromiroir sur la face du milieu actif laser destinée à être traversée par le faisceau de pompage.

Le miroir de sortie peut être un miroir concave réalisé avec un micromiroir sur la face de sortie du second matériau.

Les deux cavités Fabry-Pérot peuvent être réalisées de façon à être optiquement stable.

Selon une variante, qui permet d'obtenir un microlaser fonctionnant en mode actif, et ayant une structure encore plus simple, la cavité microlaser est en limite de stabilité optique, et des moyens sont prévus pour faire varier la longueur optique de la cavité de façon à la faire passer d'un état optiquement instable à un état optiquement stable.

Ainsi, on réalise un nouveau déclenchement actif, puisque l'état optiquement instable est un état à fortes pertes de la cavité, au contraire de l'état optiquement stable.

En outre, la structure obtenue est radicalement différente de la structure connue comme par exemple celle décrite dans l'article de J.J. Zayhowski (voir référence ci-dessus), puisqu'il n'y a plus qu'une seule cavité Fabry-Perot.

La cavité peut être une cavité hémisphérique, confocale, concentrique ou sphérique. Dans ce cas, la taille du faisceau dans la cavité est plus faible, et il est alors possible de diminuer les épaisseur de matériaux employés. La taille du microlaser s'en trouve encore diminuée. Ceci a pour conséquence de permettre de résoudre l'un des problèmes mentionnés ci-dessus, à savoir celui de la valeur importante de la tension à appliquer si le second matériau est un matériau électrooptique : en effet, l'épaisseur de ce dernier diminuant, le même champ électrique est obtenu pour une tension plus faible ( $\vec{E}=\Delta V/e$, où $e$ est l'épaisseur entre les électrodes).

Selon un mode particulier de réalisation, la cavité microlaser comporte, outre le milieu actif laser, un second matériau de longueur optique variable. Ceci ne nécessite cependant toujours qu'une seule cavité Fabry-Perot, et non pas deux.

On obtient ainsi une structure très compacte, monolithique.

Les moyens pour faire varier la longueur optique de la cavité peuvent comporter des moyens pour faire varier la longueur du second matériau.

Selon un autre mode de réalisation, le milieu actif laser et le second matériau ont des indices optiques différents et les moyens pour faire varier la longueur optique de la cavité comportent des moyens pour faire varier l'indice optique du second matériau.

Le second matériau peut être un matériau électro-optique.

Ainsi, une seule cavité microlaser est fabriquée, dont on modifie la longueur optique pour déplacer la cavité du domaine instable à forte perte, au domaine stable à faible perte ce qui permet de la déclencher. Il n'est besoin que d'une seule cavité Fabry-Perot, même si elle contient plusieurs matériaux (le matériau actif laser, et le matériau de longueur optique variable).

Lorsque les matériaux sont juxtaposés ou collés 5 ou qu'ils adhèrent l'un à l'autre par adhérence moléculaire, la compacité du système est améliorée, ce qui est très important dans le cas d'un microlaser.

Brève description des figures

De toute façon, les caractéristiques et avantages de l'invention apparaîtront mieux à la lumière de la description qui va suivre. Cette description porte sur les exemples de réalisation, 5 donnés à titre explicatif et non limitatif, en se référant à des dessins annexés sur lesquels :

- la figure 1 représente des compositions semiconductrices réparties d'après leur température de fonctionnement et leur longueur d'onde d'émission,
- les figures 2, 4A et 4B représentent divers modes de réalisation de l'invention,
- la figure 3 représente un dispositif non conforme à l'invention,
- les figures 5 à 7 représentent des structures de lasers à semi-conducteurs pompés par microlaser,
- les figures 8 et 9 représentent des dispositifs selon l'invention, avec microlentille en sortie du semi-conducteur,
- les figures 10A à 10E illustrent des étapes de réalisation d'un dispositif selon l'invention,
- les figures 11 à 17 représentent des microlasers déclenchés activement.

Description détaillée de modes de réalisation de l'invention

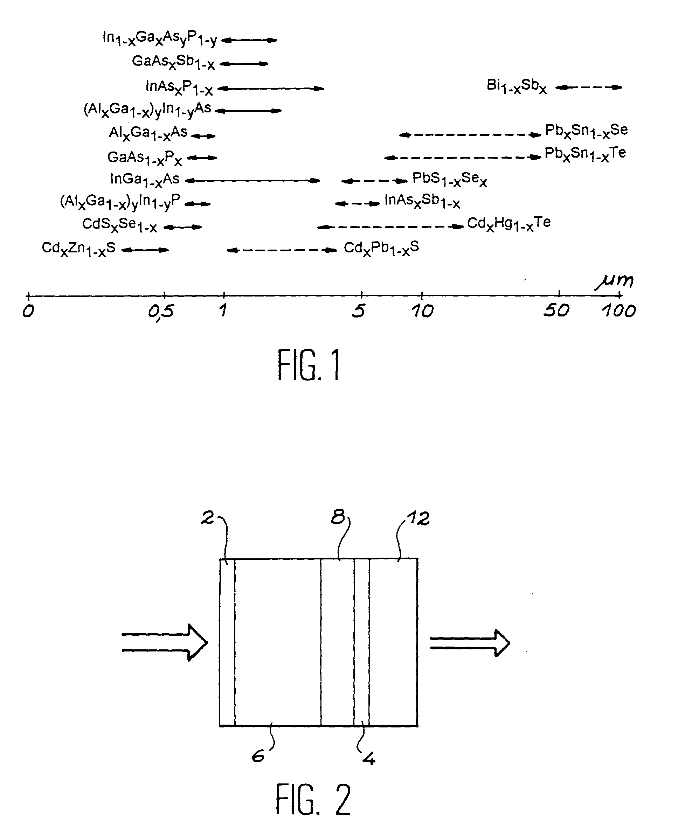

L'élément semi-conducteur mis en oeuvre dans un dispositif selon la présente invention peut être choisi en fonction de la longueur d'onde souhaitée par l'utilisateur. En particulier, le semi-conducteur peut être choisi parmi les alliages II-VI, III-V ou IV-VI connus. Par exemple, ce peut être un élément tel que l'un de ceux mentionnés sur la figure 1, en liaison avec les gammes de longueur d'onde correspondante. Les éléments situés dans la partie droite de cette figure et dont les gammes de longueur d'onde sont indiquées par des flèches en trait interrompu sont particulièrement intéressants puisqu'ils ne peuvent être mis en oeuvre, de façon classique, qu'à des températures très basses, inférieures à 160 K. Notamment, un semi-conducteur à base de $Bi_{1-x}Sb_x$ nécessite une température aussi basse que 16 K pour pouvoir fonctionner.

Un élément semi-conducteur d'un dispositif selon l'invention peut se présenter soit sous la forme d'une lame, par exemple polie sur ses deux faces, et d'épaisseur inférieure à quelques centaines de micromètres, par exemple 500 μm. Selon une variante, il est possible de réaliser une couche épitaxiée d'un alliage semi-conducteur, les techniques d'épitaxie de ces alliages étant par ailleurs connues (épitaxie en phase liquide, épitaxie par jet moléculaire, épitaxie organométallique : par exemple, la croissance d'un alliage HgCdTe par cette dernière technique est décrite dans l'article de A. RAVID déjà mentionné dans l'introduction à la présente demande).L'épitaxie de la couche est réalisée sur un substrat de préférence transparent à la longueur d'onde d'émission de l'élément semi-conducteur : dans le cas d'un semi-conducteur à base de CdHgTe, on prendra par exemple un substrat de CdZnTe avec 4% de Zn. Par ailleurs, par ces techniques d'épitaxie, il est possible de réaliser des hétérostructures avec ou sans puits quantique, par exemple une hétérostructure à base de CdHgTe.

Un exemple de dispositif selon la présente invention est illustré sur la figure 2. Les références 2 et 4 désignent des miroirs d'entrée et de sortie d'une cavité microlaser qui comporte également un milieu actif laser solide 6 et des moyens 8 de déclenchement, en mode actif ou passif, de cette cavité microlaser. La cavité peut être pompée par des moyens non représentés sur la figure, le faisceau de pompage étant désigné par la référence 10. Les impulsions émises par le microlaser vont être absorbées par l'élément semi-conducteur désigné par la référence 12, dont la composition et la structure peuvent être celles décrites ci-dessus. L'élément semi-conducteur 12 sera par exemple collé sur la face de sortie du microlaser.

Le microlaser émet en général des impulsions lasers brèves (1 à 5 nanosecondes) de forte puissance crête (plusieurs kilowatts) et à forte cadence (5 à 100 kilohertz) avec une longueur d'onde d'émission se situant aux alentours de 1 μm (par exemple YAG:Nd à 1,064 μm). L'absorption du faisceau du microlaser, par le semi-conducteur, va générer dans ce dernier des paires électrons-trous, qui vont se combiner très rapidement (en un temps de l'ordre de la nanoseconde) pour émettre des photons dont la longueur d'onde est déterminée par la composition du semi-conducteur, ainsi qu'on l'a expliqué ci-dessus. Cette très grande rapidité de la recombinaison des paires électrons-trous justifie le besoin d'une source laser émettant des impulsions très brèves : pour cette raison, un microlaser déclenché convient particulièrement bien à cette application.

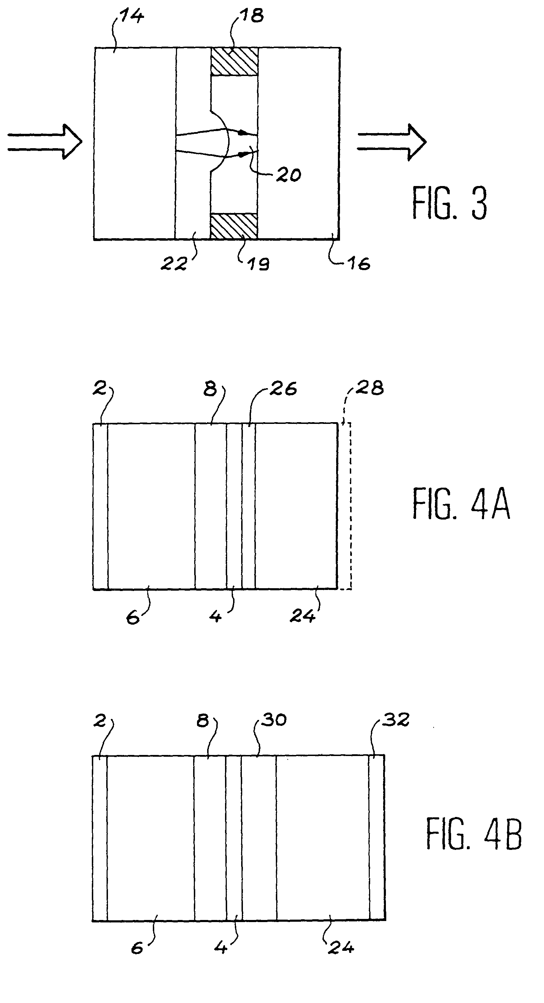

Un dispositif non conforme à l'invention est illustré sur la figure 3, où la référence 14 désigne globalement l'ensemble du microlaser déclenché, la référence 16 désigne l'élément semi-conducteur. Ce dernier est séparé de la face de sortie du microlaser par des éléments espaceurs 18, 19. En outre, des moyens 22 pour la mise en forme du faisceau 20 émis par le microlaser peuvent être prévus, en sortie du microlaser 14. Ces moyens peuvent être par exemple des microlentilles en silice hybridées (par collage ou contact face à face) avec le miroir de sortie de la cavité microlaser. Ces moyens permettent la focalisation du faisceau 20 sur ou dans l'élément semi-conducteur 16.

Des dépôts de couches optiques peuvent être réalisés sur les faces de l'élément semi-conducteur. Par exemple, comme illustré sur la figure 4A, où des références numériques identiques à celles de la figure 2 désignent les mêmes éléments, une couche 26 d'un traitement antireflet à la longueur d'onde du microlaser peut être déposée sur la face d'entrée de l'élément semi-conducteur 24, afin que tout le faisceau provenant du microlaser entre dans l'élément semi-conducteur. Une couche 28 d'un traitement antireflet (représenté en pointillés sur la figure 4A) à la longueur d'onde d'émission du semi-conducteur peut être déposée sur la face de sortie de ce dernier, afin que toute la lumière que cet élément engendre sorte par cette face.

Une autre variante est illustrée sur la figure 4B, où des références identiques à celles de la figure 4A désignent des mêmes éléments, les références 30 et 32 désignant des miroirs d'entrée et de sortie d'une cavité laser comportant en outre l'élément semi-conducteur 24. Cette cavité laser permet d'obtenir un faisceau laser émis par le semi-conducteur. Les miroirs 30, 32 doivent avoir les caractéristiques suivantes :

- miroir 30 d'entrée (de préférence un miroir dichroïque) : transmission maximum à la longueur d'onde du microlaser et réflexion maximum à la longueur d'onde du semi-conducteur,
- miroir 32 de sortie (de préférence également un miroir dichroïque) : transmission de l'ordre de quelques pourcents à la longueur d'onde du faisceau émis par le semi-conducteur.

Dans tous les cas, les dépôts de couches optiques peuvent être constitués de multicouches diélectriques. Les dépôts de miroir peuvent éventuellement être constitués de multicouches à semi-conducteurs réalisées par épitaxie.

Dans le mode de réalisation illustré sur la figure 4B, le laser semi-conducteur est en contact direct avec le miroir de sortie 4 du microlaser. Non conforme à l'inventions, le miroir d'entrée 30 du laser semi-conducteur peut être disposé à une certaine distance non nulle du miroir de sortie 4 du microlaser, par exemple à l'aide d'éléments espaceurs, comme illustré sur la figure 3, avec ou sans éléments de focalisation intermédiaires.

Dans tous les cas, la structure obtenue est extrêmement compacte, puisque le microlaser peut avoir au plus quelques mm d'épaisseur (compte tenu de l'élément déclencheur 8) et que l'élément semi-conducteur, avec ou sans substrat, a une épaisseur maximum de l'ordre du mm. Les structures qui ont été décrites ci-dessus sont donc extrêmement compactes, indéréglables (et, donc, aucun alignement n'est à réaliser en cours d'utilisation). Par ailleurs, toutes ces structures sont compatibles avec les modes de fabrication collectifs utilisés en microélectronique.

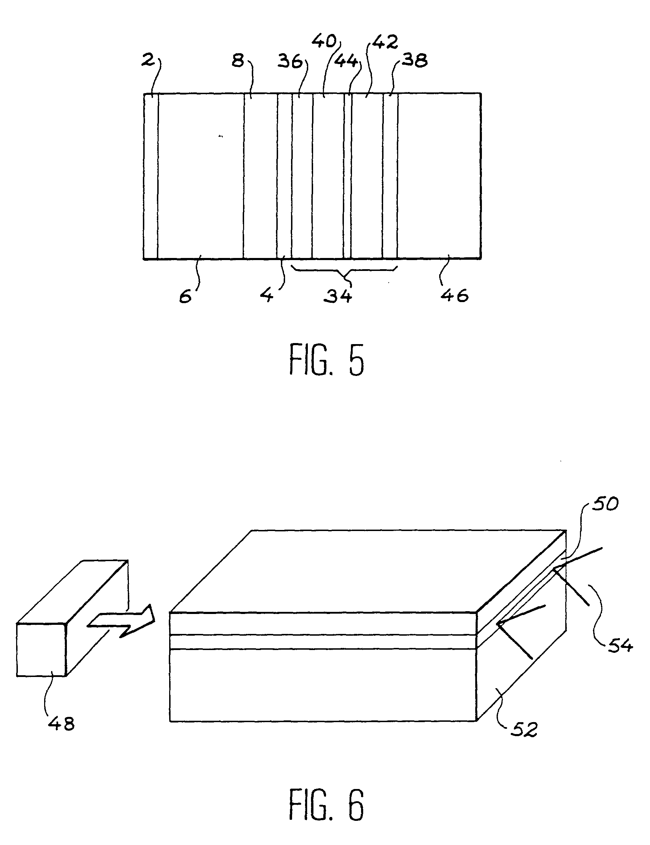

Comme illustré sur la figure 5, un laser à semi-conducteur laser de type VCSEL ("Vertical Cavity Surface Emitting Laser") peut être pompé par un microlaser. Sur cette figure, les références 2, 4, 6, 8 désignent les mêmes éléments que sur les figures 4A, 4B et 2. La cavité du laser semi-conducteur est délimitée par deux miroirs 36, 38. Le miroir 38 de sortie est réalisé par épitaxie sur un substrat 46 et présente une réflectivité élevée à la longueur d'onde du semi-conducteur. Dans une structure VCSEL, l'épaisseur de la cavité Fabry-Pérot est très faible (de l'ordre de 1 $\mu$m), il est donc possible de réaliser un laser monomode. Sur la figure 5, la référence 44 désigne une couche qui permet de réaliser une structure à puits quantique. Les lasers de type VCSEL ainsi que leurs caractéristiques sont par exemple décrits dans "Surface emitting Semiconductor Laser" de K. IGA et al., IEEE J. Quantum Electronics, 24, p. 1845 (1988).

Un laser à semi-conducteur pompé, conformément à la présente invention, par un microlaser peut présenter, comme illustré sur la figure 6, une structure de guide d'onde. Sur cette figure, la référence 48 désigne globalement le microlaser de pompage, une zone active 50 d'un laser à semi-conducteur étant déposée sur un substrat 52. Un faisceau infrarouge 54 est émis par le laser à semi-conducteur.

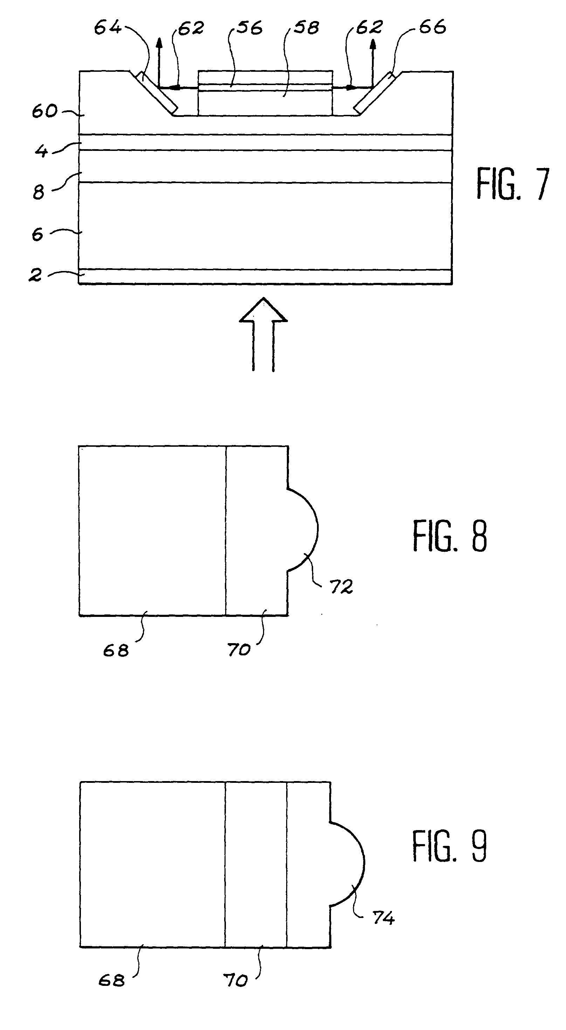

Un autre mode de réalisation d'un laser à semi-conducteur pompé par microlaser est illustré sur la figure 7. La zone active 56 du semi-conducteur est déposée sur un substrat 58 qui est transparent à la longueur d'onde du faisceau de pompage émis par le microlaser. Ce substrat 58 peut éventuellement reposer sur un second substrat 60 présentant la même propriété de transmission à la même longueur d'onde. Le substrat 58 et la couche active 56 sont disposés de manière sensiblement perpendiculaire au faisceau de pompage et l'émission résultante se fait suivant une direction 62 elle-même perpendiculaire à ce faisceau de pompage. Afin d'obtenir un faisceau parallèle au faisceau de pompage des miroirs 64, 66 peuvent être déposés sur des faces gravées de substrat 60. Selon un exemple de réalisation, si la zone active est à base de CdHgTe le substrat 58 peut être en CdZnTe qui est transparent à environ 1 $\mu$m.

Le matériau constitutif du milieu actif 6 du microlaser sera par exemple dopé au néodyme (Nd), pour une émission laser autour de 1,06 $\mu$m. Ce matériau peut aussi être choisi, par exemple, parmi l'un des matériaux suivants : YAG ($Y_3Al_5O_{12}$), LMA ($LaMgAl_{11}O_{19}$), $YVO_4$, YSO ($Y_2SiO_5$), YLF ($YLiF_4$) ou $GdVO_4$, etc.

Parmi les matériaux connus, ceux qui sont les plus adaptés au fonctionnement du microlaser sont :

- $YVO_4$, qui présente un bon coefficient et une large bande d'absorption ainsi qu'une bonne section efficace,
- YAG, dont le coefficient d'absorption et la section efficace d'émission stimulée sont moyens et dont les largeurs de bandes d'absorption et d'émission sont faibles. Il se présente sous de grandes dimensions et a une bonne conductivité thermique,

- LMA : ce matériau offre un coefficient d'absorption et une section efficace faibles. Les bandes d'absorption et d'émission sont larges. Il peut en outre présenter de grandes dimensions.

Quant aux ions actifs (dopants), ils sont, en général choisis parmi :

- Nd pour une émission autour de 1,06 μm,
- Er ou un codopage erbium-ytterbium Er+Yb pour une émission autour de 1,5 μm,
- Tm ou Ho ou un codopage de thulium et d'holmium pour une émission autour de 2 μm.

Un autre paramètre est l'épaisseur $\underline{e}$ du milieu actif du microlaser, qui conditionne les caractéristiques de ce dernier :

- d'une part, l'absorption du faisceau pompe sera d'autant plus forte que l'épaisseur e sera grande ;
- d'autre part, le nombre de modes longitudinaux d'une cavité Fabry-Pérot augmente avec l'épaisseur et, si on veut réaliser un laser monomode longitudinal, cette épaisseur doit être faible.

Si dg est la largeur de la bande de gain (d'émission laser) du matériau, le nombre de modes N sera donné par :

$$N = dg/dv \text{ avec } dv = \frac{C}{2nL},$$

où C est la vitesse de la lumière et n l'indice de réfraction du matériau.

Pour un laser monofréquence, on choisit en général l'épaisseur minimum pour N=1, à condition que cette épaisseur soit >100 μm. Les épaisseurs typiques pour obtenir un seul mode sont :

- YAG L = 750 μm,
- YVO$_4$ L = 500 μm,
- LMA L = 150 μm.

En pratique l'épaisseur e variera donc entre 100 μm et environ 1 mm.

Pour réaliser une cavité laser complète, le milieu actif 6 avec l'élément de déclenchement 8 est compris entre deux miroirs 2, 4. Le miroir d'entrée 2, déposé par des procédés connus, sera de préférence un miroir de type dichroïque présentant une réflectivité maximum (la plus proche possible de 100%) à la longueur d'onde du laser et une transmission la plus élevée possible (>80%) à la longueur d'onde de la pompe (en général vers 800 nm pour les matériaux dopés Nd, vers 980 nm pour ceux dopés Er et vers 780 nm pour ceux dopés Tm). Le miroir de sortie 4 est également de préférence de type dichroïque mais laisse passer quelques pour cent du faisceau laser.

Le pompage de la cavité microlaser sera préférentiellement un pompage optique. Ainsi, les diodes laser III-V sont particulièrement bien adaptés pour pomper une cavité microlaser.

De façon optionnelle, il est possible de fabriquer par une méthode connue selon l'art antérieur (A. Eda et al., CLEO'92, paper CWG33, p.282 (Conf. on Laser and Electro-optics, Anaheim, USA, May 1992)) un réseau de microlentilles en un matériau transparent (silice,...) sur la surface d'entrée du matériau laser 6. Les dimensions typiques de ces microlentilles sont :

- diamètre de cent à quelques centaines de microns,
- rayons de courbure de quelques centaines de micromètres à quelques millimètres.

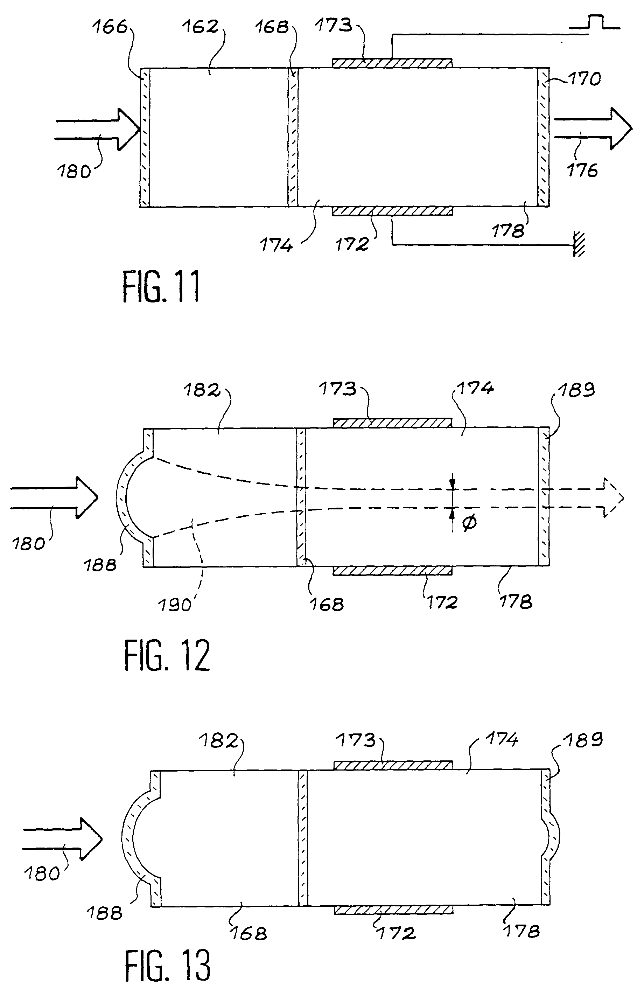

Ces microlentilles servent à réaliser des cavités "stables" (la cavité "plan-plan" n'est pas stable) du type plan-concave. Elles permettent également dans le cas d'un pompage optique, de focaliser le faisceau pompe et de diminuer la taille des faisceaux, à la fois dans la cavité microlaser et dans le milieu semi-conducteur. Des exemples de telles structures sont décrites plus loin, en liaison avec les figures 12-15.

La stabilisation de la cavité permet en outre d'y diminuer les pertes et d'accroître son rendement de fonctionnement.

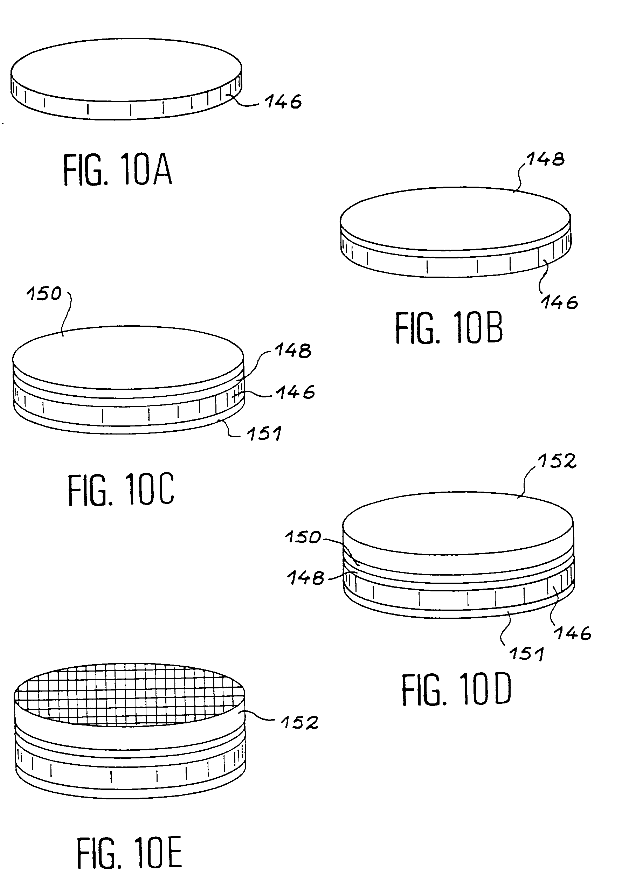

La méthode mentionnée ci-dessus peut également permettre de réaliser des microlentilles en sortie du semi-conducteur, ce qui permet de mettre en forme le faisceau de sortie du semi-conducteur. Une telle structure est illustrée sur la figure 8, où le microlaser de pompage est globalement désigné par la référence 68 et l'élément semi-conducteur par la référence 70, une microlentille 72 étant formée en sortie de l'élément 70. Selon une variante (figure 9), une microlentille 74 peut être préalablement réalisée dans un matériau, par exemple de la silice, puis fixée sur le trajet du faisceau infrarouge émis par le semi-conducteur : elle peut être par exemple collée contre la face de sortie de ce dernier.

Selon un mode particulier de réalisation, la cavité microlaser est déclenchée passivement. Dans ce cas, l'élément déclencheur 8 est un élément absorbant saturable.

Selon un mode particulièrement avantageux, l'absorbant saturable se présente sous la forme d'une couche mince. En particulier, il peut être avantageux de déposer la couche mince d'absorbant saturable directement sur le milieu amplificateur laser.

Deux types de couches minces peuvent être utilisés :

- un polymère contenant les molécules d'absorbant saturable. Typiquement pour un microlaser à 1,06 μm, on pourra utiliser, en tant qu'absorbant saturable, un colorant organique comme le bis (4-diéthylaminodithiobenzyl)nickel (BDN, Kodak, CAS N°51449-18-4) dans une solution contenant, en masse, 6% de poly(méthylméthacrylate) (PMMA) dans du chlorobenzène.

Des variantes sont décrites plus loin, en liaison avec la description d'un procédé de préparation.

Ce type de solution sera déposé à la tournette, directement sur le matériau laser (voir plus loin pour le procédé de préparation). On réalise ainsi des couches minces ayant une épaisseur de l'ordre de 1 à 5 µm par exemple 2µm, 3µm, 4µm.

- un autre type de couches minces sera obtenu par épitaxie en phase liquide (EPL), directement sur le matériau laser ou par tout autre procédé permettant de réaliser le même dépôt (même matériau, même dopage, mêmes propriétés) : la couche mince sera donc, de façon plus générale, susceptible d'avoir été obtenue par EPL. Le procédé de préparation par EPL est décrit plus loin et permet d'obtenir, sur le substrat constitué par le milieu actif solide, une couche d'épaisseur comprise entre 1 µm et 500 µm (par exemple : 100µm, 200µm, 300µm, 400µm). Elle est constituée d'un matériau de base identique au matériau de base du milieu actif solide (par exemple YAG), mais elle est dopée avec des ions lui conférant des propriétés d'absorbant saturable, par exemple du $Cr^{4+}$ pour un laser à 1,06 µm ou du $Er^{3+}$ pour un laser autour de 1,5 µm.

En fait, on adapte le type de dopant au laser que l'on veut déclencher, afin que la couche épitaxiée présente une absorption saturable à la longueur d'onde d'émission de ce laser.

Par conséquent, dans ce cas, le matériau actif laser et la couche d'absorbant saturable sont de même structure cristalline et ne se différencient que par les différents dopants qui affectent les propriétés cristallines et optiques de ces deux milieux.

Les propriétés de la couche mince, dans l'un et l'autre cas, seront très différentes.

Ainsi, on définit pour chaque type de couche, le seuil de dommage. Au-delà d'une certaine densité de puissance présente dans la cavité laser, on peut détruire la couche mince d'absorbant saturable. Cette densité de puissance limite, appelée seuil de dommage sera plus faible dans le cas du polymère avec colorant organique que dans le cas de la couche mince déposée par EPL. Dans le premier cas, il faudra donc travailler avec des énergies déposées dans la cavité plus faibles que dans le second cas.

D'autre part, dans un cas, la différence d'indice entre le matériau laser et le polymère introduit une interface optique entre les deux milieux. Dans l'autre cas, on ne peut faire l'EPL que sur le même matériau (par exemple YAG sur YAG, seul le dopage étant différent), ce qui permet d'ajuster l'indice de la couche épitaxiée à celle du milieu actif laser (qui sert de substrat d'épitaxie) et, donc, d'éviter la formation d'une interface optique entre les deux milieux.

Enfin, la nature de la couche mince influera sur la forme temporelle de l'impulsion laser. Dans le cas du colorant organique en solution dans un polymère, le temps de déclin du colorant est très court (~1ns), alors que dans le cas de la couche épitaxiée les ions constituant les impuretés ($Cr^{4+}$, $Er^{3+}$) ont des temps de déclin un peu plus long (de l'ordre de quelques nanosecondes). Ces propriétés conditionneront évidemment le choix de la couche mince en fonction de l'utilisation prévue. Dans tous les cas, ces temps de déclin sont tout à fait compatibles avec les durées de vie des états excités dans le semi-conducteur (de quelques centaines de ps à 1 ns).

La structure qui vient d'être décrite (absorbant saturable sous forme de couche mince déposée directement sur le milieu actif laser) permet d'obtenir une cavité microlaser compacte, ne nécessitant aucun alignement, ne nécessitant l'introduction d'aucun élément parasite tel qu'une colle optique, et permet en outre de ne pas recourir au codopage d'un même milieu de base pour former, à partir de ce même milieu de base, le milieu actif laser et le déclencheur passif.

Un procédé de fabrication d'un dispositif selon la présente invention, avec microlaser déclenché passivement, va maintenant être décrit, pour réaliser une structure conforme à celle de la figure 2.

On peut distinguer, dans un tel procédé, les étapes suivantes :

1) - le matériau actif laser est choisi et conditionné : il est orienté et découpé en lames 146 d'épaisseur comprise entre 0,5 et 5mm (figure 10A). Les lames sont ensuite rodées et polies, ce qui permet d'atteindre l'épaisseur finale e voulue,

2)- une étape de préparation de l'absorbant saturable 148 (figure 10B),

2a) Dans le cas d'un absorbant saturable classique, divers procédés sont connus, qui permettent de réaliser une cavité microlaser déclenchée. En particulier, il est possible de réaliser un codopage du matériau de base du milieu actif laser, afin de lui conférer des propriétés de milieu actif laser et d'absorbant saturable (par exemple, YAG dopé avec des ions néodyme $Nd^{3+}$ et chrome $Cr^{4+}$).

2b) Dans le cas d'un absorbant saturable déposé sous forme de couche mince, deux types de dépôt peuvent être réalisés :

2b1) - 1er type de dépôt : dépôt d'un colorant organique absorbant saturable, en solution dans un polymère.

Typiquement, pour un microlaser fonctionnant à 1,06 µm, on peut utiliser, comme absorbant saturable un colorant organique comme le bis(4-diéthylamino-dithiobenzyl)nickel (BDN, Kodak, CAS N° 51449-18-4) dans une solution de poly (méthylméthacrylate) (PMMA).

Pour cela, on prépare une solution contenant en masse 6% de poly(méthylméthacrylate) (PMMA, masses moyennes Polyscience) dans du chlorobenzène (Prolabo) en agitant 24 heures. On y rajoute 0,2% en masse de BDN et on agite encore 2 heures. La solution est ensuite filtrée et déposée sur le substrat, sur la face de sortie au goutte à goutte avec un mouvement circulaire centrifuge. On peut utiliser pour ce dépôt à la "tournette" une machine standard telle que celle utilisée en microélectronique pour le dépôt des résines servant aux opérations de lithogravure. Le substrat est préalablement nettoyé de toutes les traces d'impuretés résultant du polissage. Il est mis en rotation (tournette) pendant 20 secondes à 2000 tours/minute, puis pendant 30 secondes à 5000 tours/minute. La couche est enfin mise à sécher 2 heures dans un four à 70°C.

On obtient ainsi un film de 1 μm d'épaisseur contenant 3% de molécules actives (BDN) et dont la densité optique est de 0,13 à 1,06 μm (74% de transmission) avant saturation.

En variant les paramètres de concentration du polymère, sa masse moléculaire ou son solvant, la proportion de colorant ainsi que la vitesse de rotation de la tournette, on peut ajuster les performances de l'absorbant saturable. Les spécifications obtenues typiquement sont :

- épaisseur du film : 1 à 5 μm (par exemple 2μm, 3μm, 4μm),
- densité de molécules : 5 à 10% en masse,
- colorant : BDN, mm=685g,
- transition vitreuse : Tg=78°C,
- absorption à 1,06 μm : 10 à 70%,
- taux de saturation : 90%,
- section efficace : $10^{-16}cm^2$,
- intensité de saturation : 0,1 à 1 MW/cm$^2$,
- non-uniformité du film : <5% sur 1cm$^2$,
- taux de dépolarisation : $<10^{-5}$,
- pertes à 800 nm : <1%,
- fréquence de récurrence : 10-10000 Hz,
- photostabilité : $10^8$ coups.

D'autres polymères tels que le poly(vinylalcool) ou le poly(vinylacétate) ou encore poly(styrène) peuvent être employés dans leurs solvants respectifs) à la place du PMMA. On peut aussi utiliser le bis(4-diméthylaminodithiobenzyl)nickel (BDN, Kodak, CAS N°38465-55-3) comme colorant.

Le colorant peut aussi être incorporé dans un gel de silice ou bien greffé à même la chaîne de polymère.

De nombreux autres complexes métalliques de dithiene peuvent servir de colorant pour d'autres longueurs d'onde, comme décrit dans les articles de K.H. Drexhage et al., Optics Communication 10(1), 19(1974) et de Mueller-Westerhoff, Mol. Cryst. Liq. Cryst. 183, 291 (1990).

La technique peut aussi être employée pour le déclenchement de lasers fonctionnant à d'autres longueurs d'ondes que 1,06 μm. On déclenchera par exemple des lasers à Er ou Er+Yb (matériaux dopé Er ou Er+Yb où l'ion actif est Er) émettant autour de 1,5 μm avec du tétraéthyloctahydrotétraazapentaphène-dithiolato-nickel (voir article de Mueller-Westerhoff cité ci-dessus).

## 2b2) - 2ème type de dépôt : dépôt d'une couche mince par épitaxie en phase liquide (EPL).

La couche A.S. (absorbant saturable) est obtenue par trempe du substrat, sur lequel on la dépose, dans une solution sursaturée convenablement choisie. Cette solution, ou bain d'épitaxie est un mélange d'un solvant et d'un soluté constitué de différents éléments formant le matériau final. Le substrat et la couche sont de même structure cristalline et ne se différencient que par les différents dopants qui affectent les propriétés cristallines et optiques de la couche. Les ions actifs tels Nd, Er, Yb rendent le matériau amplificateur, d'autres ions (Cr, Er) lui confèrent des propriétés d'A.S. et certains autres peuvent être utilisés pour faire varier l'indice de réfraction ou la maille cristalline du matériau (par exemple Ga, Ge, Lu, ...). Il est ainsi possible de contrôler les propriétés des couches réalisées.

Ce procédé peut s'appliquer à tout matériau existant sous forme de monocristaux (pour la réalisation des substrats) et pouvant être préparés par épitaxie en phase liquide. C'est le cas des matériaux cités plus haut pour le matériau de base du milieu actif laser : $Y_3A_{15}O_{12}$ (YAG), $Y_2SiO_5$ (YSO), $YVO_4$, $YLiF_4$ (YLF) ou $GdVO_4$. La composition du bain (choix du solvant et des substituants), les concentrations dans le soluté des différents oxydes et les conditions expérimentales de croissance (gamme de températures, mode opératoire, ...) sont ajustées pour chaque matériau afin d'obtenir des couches présentant la meilleure qualité cristalline possible.

Dans le cas des grenats (YAG), le solvant choisi est un mélange $PbO/B_2O_3$ et le soluté comprend un excès de $Al_2O_3$ afin de stabiliser la phase grenat. Le rapport soluté/solvant est alors calculé de façon à obtenir une croissance vers 1000°C.

En fonction de la composition du bain, de la température et du temps de dépôt, on peut ajuster l'épaisseur (1≤e≤200 μm, par exemple : 25μm, 50μm, 75μm, 100μm, 125μm, 150μm, 175μm ; il est possible également de réaliser e≥200μm) et la concentration en dopants dans les couches. La croissance d'une couche a lieu à température constante, ce qui permet d'obtenir une concentration en dopant homogène dans l'épaisseur de la couche. Le substrat est animé d'un mouvement de rotation uniforme ou alternée, ce qui permet une bonne homogénéité d'épaisseur.

On peut réaliser un substrat portant une ou deux couches d'A.S. suivant que l'on trempe une face du matériau actif laser dans le bain, en surface de celui-ci, ou les deux faces, le matériau laser étant totalement immergé dans le bain.

La (ou les) face(s) épitaxiée(s) obtenue(s) peu(ven)t être repolie(s) afin d'enlever une rugosité provoquée éventuellement par le procédé d'épitaxie et d'amener l'épaisseur de la (ou des) couche(s) épitaxiée(s) à l'épaisseur voulue pour le fonctionnement du microlaser.

3) - Une étape de dépôt des miroirs 150, 151 de la cavité microlaser (figure 10C). Il peut s'agir de miroirs dichroïques, obtenus par un dépôt de multicouches diélectriques, procédé connu de l'homme du métier et commercialement disponible.

4) - Une étape de réalisation de la partie semi-conductrice, ayant une composition et une structure comme on les a déjà décrites (couche de quelques microns épitaxiée sur un substrat, hétérostructure avec ou sans puits quantiques, etc.)

Eventuellement, cette étape est complétée par une étape de dépôt de miroirs, par exemple pour réaliser une structure comme celle de la figure 4B ou de la figure 5.

5)- Une étape de fixation, par exemple par collage, de la structure semi-conductrice 152 obtenue par l'étape précédente, sur le miroir de sortie du microlaser (figure 10D).

Pour réaliser une structure non conforme à l'invention comme celle de la figure 3, il n'y a évidemment pas de collage direct sur le microlaser.

6) - Une étape de découpe des lames pour obtenir des puces microlasers (figure 10E où les traits désignent les lignes de découpe).

Les plaquettes comportant les miroirs, l'absorbant saturable, le milieu actif laser, l'élément semi-conducteur et éventuellement les microlentilles sont découpées par une scie à disque, pour obtenir des puces de quelques mm$^2$ de section et d'environ 1-2 mm d'épaisseur, soit un volume d'environ 1 à 2 mm$^3$.

Pour réaliser une autre structure, l'homme du métier saura adapter les étapes ci-dessus. Par exemple, pour une structure comme celle de la figure 4A, une étape intermédiaire de dépôt des couches optiques 26, 28 sera prévue.

La structure de la figure 7 nécessite la préparation d'un substrat 60, mais les étapes additionnelles mises en oeuvre sont à la portée de l'homme du métier.

Selon un autre mode de réalisation de l'invention, la cavité microlaser et le microlaser sont déclenchés de manière active. Un exemple d'une telle structure microlaser est illustré sur la figure 11 (l'élément semi-conducteur n'est pas représenté sur cette figure) où la référence 162 désigne le milieu actif laser, qui forme une première cavité résonnante entre un miroir d'entrée 166 et un miroir intermédiaire 168. Une seconde cavité résonnante est formée entre le miroir intermédiaire 168 et le miroir de sortie 170. Cette seconde cavité résonnante comporte un élément 174 dont l'indice optique est apte à être modulé par une perturbation extérieure ; en particulier, ce matériau peut être un matériau électrooptique, par exemple constitué par du LiTaO$_3$. Une tension de commande externe peut être appliquée à des électrodes 172, 173, et l'application de cette tension entraîne l'établissement d'un champ électrique dans le matériau 174 et une modification de l'indice de ce matériau. Cette modification affecte le couplage des deux cavités et modifie la réflectivité du miroir intermédiaire 168 vu par le milieu actif laser.

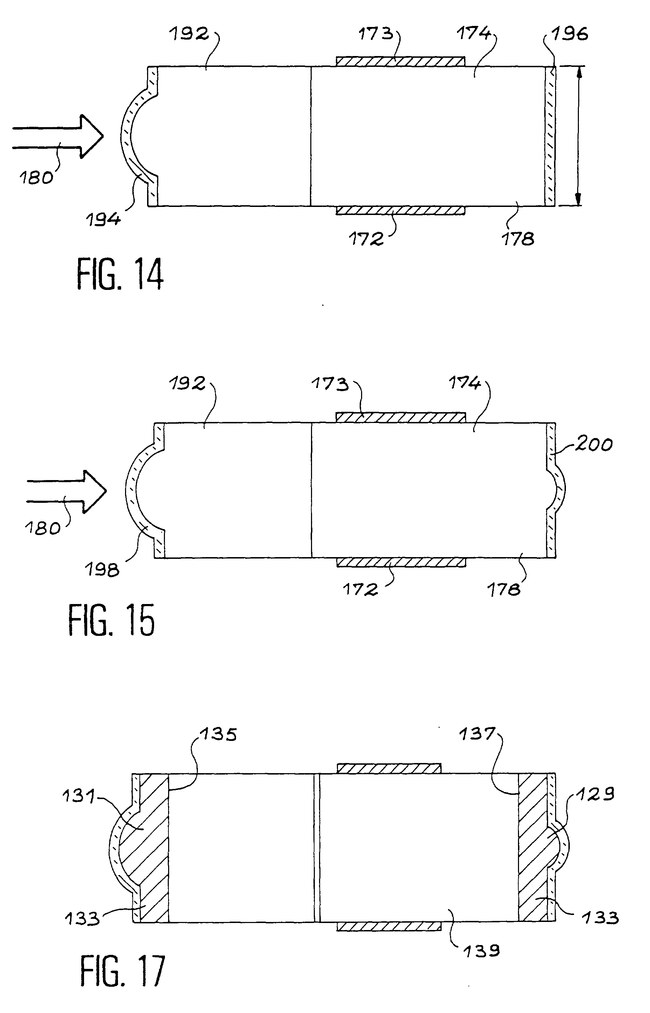

Ce mode de réalisation peut encore être perfectionné en ajoutant des moyens de réduction de la taille du faisceau laser, ces moyens étant disposés en entrée de la première cavité résonnante, l'ensemble des deux cavités et des moyens de réduction du faisceau laser étant monolithiques. Ce perfectionnement est représenté sur les figures 12 et 13, où des éléments identiques ou correspondant à ceux de la figure 11 sont désignés par les mêmes références. Des moyens de réduction de la taille du faisceau laser 190 sont désignés sur chacune de ces figures par la référence 188. Sur ces figures, ces moyens sont en fait constitués par un micromiroir 188 formé sur la face du matériau actif laser 182 qui est destinée à être traversée en premier par le faisceau de pompage 180.

Avec cette structure, il est possible de ramener l'épaisseur globale du microlaser, et en particulier l'épaisseur du matériau 174 à environ 100μm. Ceci permet, dans le cas d'un matériau électrooptique 174, de limiter la tension nécessaire à appliquer entre les électrodes 172, 173 à une valeur comprise entre 50 et 100 volts ; au contraire, dans le mode de réalisation de la figure 11 (tous les miroirs du microlaser sont plans) des tensions importantes (pouvant atteindre plusieurs centaines de volts, voire 1000 volts) doivent être appliquées entre les. électrodes 172, 173 pour pouvoir obtenir une variation d'indice suffisante permettant de déclencher la cavité. Lorsque des moyens de réduction de la taille du faisceau laser dans la cavité sont prévus, le seuil de déclenchement du microlaser est réduit à environ quelques milliwatts. Le fonctionnement de l'ensemble microlaser semi-conducteur est alors optimal.

De préférence, le rayon de courbure du micromiroir 188 est supérieur à la longueur totale du microlaser (longueur L$_1$ du milieu actif 182 + longueur L$_2$ du milieu 174). Typiquement, le rayon de courbure sera supérieur à environ 1,5-2mm. Avec cette condition, on obtient une cavité stable optiquement, et un diamètre Φ du faisceau laser 190, à l'intérieur du milieu 174, relativement petit, typiquement de l'ordre de quelques dizaines de micromètres (contre environ 120μm dans le mode de réalisation de la figure 11).

Il est également possible de réaliser, comme illustré sur la figure 13, une structure dans laquelle un micromiroir concave 189 est prévu en sortie de la deuxième cavité. De plus, les rayons R$_1$ et R$_2$ de chacun des micromiroirs 188, 189 peuvent être choisis de façon à obtenir deux cavités stables optiquement. Cette condition est en fait remplie pour : $R_1 > L_1$ et $R_2 \geq L_2$. Le cas de la cavité plan concave de la figure 12 correspond à $R2 = \infty$.

Il est également possible d'utiliser, comme milieu d'indice $n_2$ variable, de manière alternative à l'élément électrooptique 174 :

- soit un matériau magnétooptique dont l'indice $n_2$ est modifié en réponse à un champ magnétique externe, par exemple à l'aide d'un électroaimant situé à proximité de ce matériau,
- soit un matériau dont l'indice est fonction des variations de température ou des variations de pression imposées à l'extérieur.

Les structures de microlaser décrites ci-dessus peuvent être combinées avec un élément semi-conducteur, comme déjà décrit ci-dessus en liaison avec les figures 2, 4A, 4B et 5 à 9. Non conforme à l'invention, on pourra éventuellement ajouter des espaceurs (comme les éléments 18, 19 de la figure 3) entre la microlentille de sortie du microlaser (cas de la figure 13) et le semi-conducteur.

Une autre structure de microcavité laser déclenchée activement va maintenant être présentée.

Par rapport à la structure présentée ci-dessus (double cavité Fabry-Pérot, figures 11 à 13), la structure de la microcavité laser obtenue est beaucoup plus simple, et résout le problème de la complexité des structures connues de microlasers fonctionnant en mode actif. En outre, la structure obtenue permet, comme le mode de réalisation décrit en liaison avec les figures 12 à 13, de diminuer la tension de commande à utiliser, lorsqu'un matériau électrooptique est mis en oeuvre.

Selon ce mode de réalisation, la cavité microlaser comporte un milieu actif laser et deux micromiroirs formant une cavité Fabry-Pérot, cette cavité est en limite de stabilité optique, et des moyens sont prévus pour faire varier la longueur optique de la cavité microlaser de façon à la faire passer d'un état optiquement instable à un état optiquement stable.

Ainsi, un nouveau déclenchement actif est réalisé, puisque l'état optiquement instable est un état à forte perte de la cavité au contraire de l'état optiquement stable. Cette structure est radicalement différente des structures connues, puisqu'il n'y a plus qu'une seule cavité Fabry-Pérot.

Ce mode de réalisation est illustré sur les figures 14 et 15. Sur ces figures, les références 172, 173, 174, 180 désignent des éléments identiques à ceux des figures 11 à 13 qui sont désignés par les mêmes références. Par ailleurs, la référence 192 désigne le milieu actif laser, les références 194 et 198 un miroir d'entrée de la microcavité laser et les références 196, 200 un micromiroir de sortie de la microcavité laser. Les milieux 192 et 174 peuvent être en contact l'un avec l'autre, une couche antireflet pouvant être déposée à l'interface 192-174. La cavité microlaser représentée sur la figure 14 est une cavité hémisphérique, en limite de stabilité. Il s'agit d'une seule et unique cavité réalisée avec un matériau laser, et un autre matériau dont on peut faire varier l'indice optique par une tension de commande externe. Contrairement au cas des deux cavités couplées, décrites ci-dessus en liaison avec les figures 11 à 13, ces matériaux forment une seule et unique cavité Fabry-Perot. Les deux matériaux 192 et 174 peuvent être en contact par collage ou par adhérence moléculaire. A la jonction de ces deux matériaux, il peut exister une faible réflectivité de quelques % due aux différences d'indices optiques des deux matériaux, mais cette réflectivité faible ne permet pas d'obtenir une résonance suffisante pour coupler les deux cavités en résonance, comme dans les systèmes décrits dans l'art antérieur.

Le mode de réalisation de la figure 15 diffère de celui de la figure 14 en ce que le miroir de sortie 200 est un miroir concave, de rayon de courbure $R_2$.

Il reste à déterminer les caractéristiques des miroirs de façon à réaliser une cavité, par exemple confocale (avec deux miroirs concaves comme sur la figure 15) ou hémisphérique (plan concave, comme sur la' figure 14), à la limite de la stabilité.

Dans le cas de la cavité hémisphérique, la stabilité sera obtenue pour $R_1 \geq L + (n_1/n_2 - 1)L_2$, avec $L = L_1 + L_2$.

Dans le cas de la cavité confocale, la stabilité est obtenue pour :

$$R_1 \geq L + (n_1/n_2 - 1)L_2$$

$$R_2 \geq L + (n_2/n_1 - 1)L_1$$

Enfin, pour la cavité concentrique ou sphérique, la condition relative à la stabilité est :

$$R_1 = R_2 = \frac{n_2 L_1 + n_1 L_2}{n_1 + n_2}$$

Dans chaque cas, il est possible de faire varier soit l'indice $n_2$, soit l'indice $n_1$, soit l'une des longueurs $L_1$ ou $L_2$ de façon à satisfaire à l'inégalité correspondante pour amener la cavité dans un état stable. La variation de l'un de ces paramètres est obtenue par des moyens de commande externes. Comme, par ailleurs, l'état optiquement stable de la cavité correspond à un état à faible pertes et l'état optiquement instable à un état à fortes pertes, on a ainsi un nouveau moyen de déclencher activement une cavité.

Dans le cas des modes de réalisation illustrés sur les figures 14 et 15, l'indice $n_2$ du milieu électrooptique est modulé par l'application d'un champ électrique.

De manière alternative, afin de modifier la longueur optique de la cavité, il est possible de remplacer le matériau électrooptique 174 par :

- un matériau magnétooptique dont l'indice est modifié en réponse à un champ magnétique externe, par exemple à l'aide d'un électroaimant situé à proximité de ce matériau,
- un matériau dont l'indice $n_2$ dépend de la pression, la variation d'indice étant obtenue par une variation de pression.

Par ailleurs, il est possible de modifier la longueur géométrique totale de la cavité en montant le miroir de sortie sur des moyens piézoélectriques. Ceci conduit également à une variation commandée de la longueur optique de la cavité microlaser, et permet de faire passer celle-ci d'un état optiquement instable à un état optiquement stable.

Le fait d'utiliser une cavité hémisphérique, confocale, concentrique ou sphérique permet de concentrer le faisceau microlaser à l'intérieur du matériau électrooptique 174, dans le cas où un tel matériau est utilisé. La section du faisceau microlaser étant diminuée, il est possible de diminuer l'épaisseur du matériau d'indice $n_2$. Dans le cas où l'on utilise un matériau électrooptique définissant avec le matériau laser une cavité unique, on peut donc diminuer la distance nécessaire entre les électrodes de contact 172, 173 pour obtenir le champ E nécessaire à la modulation de l'indice $n_2$. La tension appliquée aux électrodes pour obtenir le même champ E s'en trouve diminuée d'autant.

Les structures de microlaser décrites ci-dessus peuvent être combinées avec un élément semi-conducteur comme déjà décrit ci-dessus en liaison avec les figures 2, et 4A à 9. Non conforme à l'invention, on pourra éventuellement ajouter des espaceurs (comme les éléments 18, 19 de la figure 3) entre la microlentille de sortie du microlaser (cas des figures 15, 17) et le semi-conducteur.

Un procédé de fabrication d'un dispositif selon la structure de la figure 2, avec microlaser déclenché activement, va être décrit.

Ce procédé comporte les mêmes étapes 1 et 3 à 6 que décrites ci-dessus en liaison avec les figures 10A à 10E pour la préparation d'un dispositif avec absorbant saturable.

La différence réside dans l'étape 2, puisqu'il s'agit maintenant de réaliser, un déclenchement actif dans le microlaser.

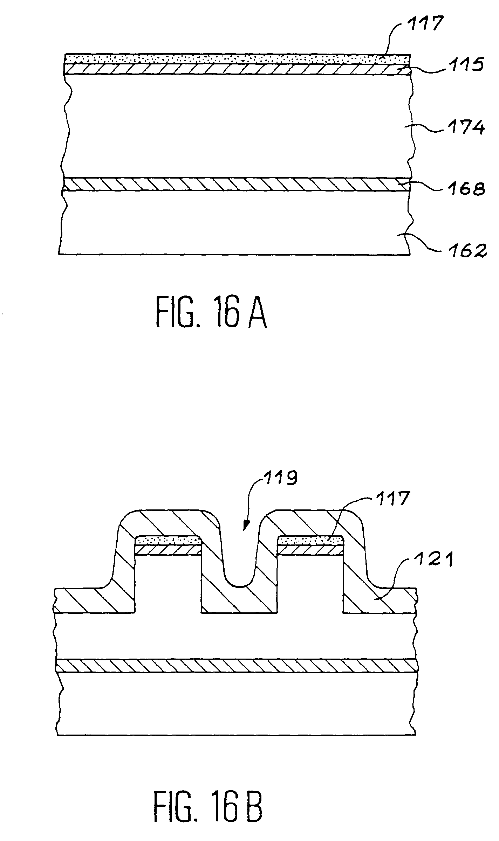

Dans le cas d'une structure microlaser avec deux cavités Fabry-Pérot couplées (figures 11 à 13), un miroir intermédiaire 168 est déposé sur le matériau laser 162 (figure 16A). Puis on dépose sur ce miroir une lame 174 d'un matériau d'indice variable, par exemple un matériau électro-optique ($LiTaO_3$). Ultérieurement, après l'étape 3 et avant l'étape 4, il est procédé aux étapes 3'-1 à 3'-4 de formation des électrodes de commande 172, 173 :

3'-1°) - On protège la face de sortie 115 du microlaser par un dépôt de résine 117.

3'-2°) - On réalise des rainures 119 (figure 16B) dans le matériau électro-optique à l'aide d'une scie à lame diamantée utilisée en micro-électronique, pour pouvoir réaliser par la suite les électrodes avec l'espacement voulu.

3'-3°) - Il est ensuite procédé au dépôt de contacts électriques par évaporation (par exemple, dépôt d'une couche Cr-Au 121 qui enrobe la résine 117 et le matériau électrooptique).

3'-4°) - Il y a ensuite décapage chimique de la résine de protection 117 pour laisser subsister des métallisations de part et d'autre du matériau électrooptique.

Dans le cas d'un microlaser comportant une cavité Fabry-Pérot unique (figures 14 et 15), on ne réalise pas le dépôt du miroir intermédiaire 168. Une couche antireflet peut alors être déposée à l'interface lame matériau laser lame matériau électrooptique. Les deux lames sont ensuite collées à l'aide d'une colle optique ou assemblées par tout autre procédé, par exemple par adhérence moléculaire.

Lorsque des micromiroirs doivent être formés sur une des faces de la cavité, on procède par photolithographie (insolation d'une résine photosensible par rayonnement U.V., à travers un masque, puis révélation chimique de la résine) et usinage par faisceau d'ions.

Dans les deux cas ci-dessus de déclenchement actif (double cavité et une seule cavité), il est possible selon une variante de fabriquer les micromiroirs avec un masque à densité variable. Par ailleurs, comme illustré sur la figure 17, des micromiroirs 129, 131 (plans ou concaves) peuvent être réalisés sur un matériau 133 comme le verre ou la silice, transparent à la longueur d'onde du laser. Ces substrats avec les micromiroirs peuvent ensuite être accolés sur les faces d'entrée 135 du milieu laser et de sortie 137 du matériau électrooptique 139.

**Revendications**

1. Dispositif pour émetteur de lumière infrarouge, comportant :

   - un élément semi-conducteur (12, 24, 40, 42, 44, 50, 56, 70) apte à émettre un rayonnement infrarouge,
   - un microlaser déclenché (2, 4, 6, 8, 48, 68) disposé de manière à pouvoir pomper optiquement l'élément semi-conducteur, l'élément semi-conducteur (12, 24, 40, 42, 44) étant directement fixé sur la face de sortie du microlaser.

2. Dispositif selon la revendication 1, l'élément semi-conducteur ayant la forme d'une lame ayant une épaisseur de quelques centaines de micromètres.

3. Dispositif selon la revendication 1, l'élément semi-conducteur ayant la forme d'une couche épitaxiée sur un substrat.

4. Dispositif selon l'une des revendication 1 à 3, l'élément semi-conducteur étant à base de $Pb_xSn_{1-x}Se$ ou de $Pb_xSn_{1-x}Te$, ou de $PbS_{1-x}Se_x$, ou de $InAs_xSb_{1-x}$ ou de $Cd_xHg_{1-x}Te$ ou de $Cd_xPb_{1-x}S$, ou de $Bi_{1-x}Sb_x$ ($0 \le x \le 1$).

5. Dispositif selon l'une des revendications 1 à 3, l'élément semi-conducteur étant à base de $In_xGa_{1-x}As$, ou de $InAs_xP_{1-x}$, ou de $Cd_xZn_{1-x}S$, ou de $(Al_xGa_{1-x})_yIn_{1-y}As$ ou de $(Al_xGa_{1-x})_yIn_{1-y}P$.

6. Dispositif selon l'une des revendications 1 à 5, au moins une des faces du semi-conducteur étant traitée antireflet (26, 28).

7. dispositif selon l'une des revendications 1 à 3, l'élément semi-conducteur (24, 40, 42, 44, 50, 56, 70) faisant partie d'un laser à semi-conducteur (34).

8. Dispositif selon la revendication 7, le laser à semi-conducteur (34) étant du type VCSEL.

9. Dispositif selon la revendication 7, le laser à semi-conducteur (50, 52, 56, 58) étant du type à guide d'onde, l'élément semi-conducteur ayant la forme d'une couche (50, 56) déposée sur un substrat (52, 58).

10. Dispositif selon la revendication 9, la couche (56) de semi-conducteur étant orientée dans un plan sensiblement perpendiculaire à la direction du faisceau émis par le microlaser.

11. Dispositif selon une des revendications 1 à 5, caractérisé en ce que le microlaser comporte des moyens optiques (123, 129, 189, 200) de mise en forme du faisceau du microlaser, une face de sortie de ces moyens constituant la face de sortie du microlaser (14).

12. Dispositif selon l'une des revendications précédentes, des moyens optiques (72, 74) de mise en forme d'un faisceau infrarouge émis par l'élément semi-conducteur (70) étant prévus en sortie de cet élément.

13. Dispositif selon l'une des revendications précédentes, la cavité microlaser étant stabilisée.

14. Dispositif selon l'une des revendications précédentes, le microlaser étant déclenché passivement.

15. Dispositif selon la revendication 14, la cavité microlaser comportant un milieu actif solide (6) et un absorbant saturable (8), ce dernier ayant la forme d'une couche mince de matériau absorbant saturable directement déposée sur le milieu actif solide.

16. Dispositif selon la revendication 15, la couche mince étant composée d'un colorant organique en solution dans un solvant polymère.

17. Dispositif selon la revendication 16, le colorant organique étant choisi parmi le bis(4-diéthylaminodithiobenzyl)nickel ou le bis(4-diméthylaminodithiobenzyl)nickel et le solvant étant une solution de poly (méthyméthacrylate) (PMMA), de poly(vinylalcool) ou de poly(vinylacétate) ou de poly(styrène).

18. Dispositif selon la revendication 15, la couche mince étant susceptible d'avoir été déposée par épitaxie en phase liquide.

19. Dispositif selon la revendication 18, la couche mince étant composée d'un matériau de base, identique à celui du milieu actif solide et dopé avec des ions $Cr^{4+}$ ou $Er^{3+}$.

20. Dispositif selon l'une des revendications 1 à 13, le microlaser étant déclenché activement.

21. Dispositif selon la revendication 20, le milieu actif laser (162, 182) formant une première cavité résonnante entre un miroir d'entrée (166, 188) et un miroir intermédiaire (168), un second matériau (174) formant une seconde cavité résonnante entre le miroir intermédiaire (168) et un miroir de sortie (189), l'indice optique de ce second matériau (174) étant apte à être modulé par une perturbation extérieure, et des moyens (188) de réduction de la taille du faisceau laser étant disposés en entrée de la première cavité résonnante, l'ensemble des deux cavités et des moyens de réduction du faisceau laser étant monolithique.

22. Dispositif selon la revendication 21, les moyens de réduction étant constitués par un miroir concave réalisé avec un micromiroir (188) sur la face du milieu actif laser (182) destinée à être traversée par le faisceau de pompage (180) du microlaser.

23. Dispositif selon l'une des revendications 21 ou 22, le miroir de sortie (189) étant un miroir concave réalisé avec un micromiroir sur la face de sortie du second matériau (174).

24. Dispositif selon la revendication 20, le milieu actif laser (192), et deux miroirs (194, 198 ; 196, 200) formant une cavité Fabry-Pérot, cette cavité étant en limite de stabilité optique, et des moyens (172, 173) étant prévus pour faire varier la longueur optique de la cavité de façon à la faire passer d'un état optiquement instable à un état optiquement stable.

**25.** Dispositif selon la revendication 24, la cavité étant une cavité hémisphérique, confocale, concentrique ou sphérique.

**26.** Dispositif selon l'une des revendications 24 ou 25, la cavité comportant un second matériau (174) de longueur optique variable.

**27.** Dispositif selon la revendication 26, les moyens pour faire varier la longueur optique de la cavité comportant des moyens pour faire varier la longueur du second matériau.

**28.** Dispositif selon la revendication 26, le matériau constitutif du milieu actif laser (192) et le second matériau (174) étant d'indice optique différent et les moyens pour faire varier la longueur optique de la cavité comportant des moyens (172, 173) pour faire varier l'indice optique du second matériau.

**29.** Dispositif selon l'une des revendications 26 ou 28, le second matériau (174) étant un matériau électrooptique.

**Claims**

**1.** Device for an infrared light emitter incorporating a semiconductor element (12, 24, 40, 42, 44, 50, 56, 70) able to emit infrared radiation and a Q switched microlaser (2, 4, 6, 8, 48, 68) arranged so as to be able to optically pump the semiconductor element (12, 24, 40, 42, 44), which is directly fixed to the output face of the microlaser.

**2.** Device according to claim 1, the semiconductor element being in the form of a plate with a thickness of a few hundred micrometers.

**3.** Device according to claim 1, the semiconductor element being in the form of a film epitaxied on a substrate.

**4.** Device according to one of the claims 1 to 3, the semiconductor element being based on $Pb_xSn_{1-x}Se$ or $Pb_xSn_{1-x}Te$, or $PbS_{1-x}Se_x$, or $InAs_xSb_{1-x}$ or $Cd_xHg_{1-x}Te$ or $Cd_xPb_{1-x}dS$, or $Bi_{1-x}Sb_x$ ($0 \le x \le 1$).

**5.** Device according to one of the claims 1 to 3, e semiconductor element being based on $In_xGa_{1-x}As$, or $InAs_xP_{1-x}$, or $Cd_xZn_{1-x}S$, or $(Al_xGa_{1-x})yIn_{1-y}As$ or $(Al_xGa_{1-x})yIn_{1-y}P$.

**6.** Device according to one of the claims 1 to 5, at least one of the semiconductor faces (26, 28) being given an antireflection treatment.

**7.** Device according to one of the claims 1 to 3, the semiconductor element (24, 40, 42, 44, 50, 56, 70) forming part of a semiconductor laser (34).

**8.** Device according to claim 7, the semiconductor laser (34) being of the VCSEL type.

**9.** Device according to claim 7, the semiconductor laser (50, 42, 56, 58) being of the waveguide type, the semiconductor element being in the form of a film (50, 56) deposited on a substrate (52, 58).

**10.** Device according to claim 9, the semiconductor film (56) being oriented in a plane substantially perpendicular to the direction of the beam emitted by the microlaser.

**11.** Device according to one of the claims 1 to 5, characterized in that the microlaser has optical means (123, 129, 189, 200) for shaping the microlaser beam, an output face of said means constituting the output face of the microlaser (14).

**12.** Device according to any one of the preceding claims, optical means (72, 74) for shaping an infrared beam emitted by the semiconductor element (70) being provided at the output of said element.

**13.** Device according to any one of the preceding claims, the microlaser cavity being stabilized.

**14.** Device according to any one of the preceding claims, the microlaser being passively switched.

**15.** Device according to claim 14, the microlaser cavity incorporating a solid active medium (6) and a saturable absorber (8), the latter being in the form of a saturable absorber material film directly deposited on the solid active medium.

**16.** Device according to claim 15, the film being formed from an organic dye dissolved in a polymer solvent.

**17.** Device according to claim 16, the organic dye being chosen from among bis(4-diethylaminodithiobenzyl) nickel or bis(4-dimethylaminodithiobenzyl) nickel and the solvent being a solution of polymethyl methacrylate, polyvinyl alcohol, polyvinyl acetate or polystyrene.

**18.** Device according to claim 17, the film being depositable by liquid phase epitaxy.

**19.** Device according to claim 18, the film being formed from a basic material identical to that of the active solid material and doped with $Cr^{4+}$ or $Er^{3+}$ ions.

20. Device according to one of the claims 1 to 13, the microlaser being actively switched.

21. Device according to claim 20, the active laser medium (162, 182) forming a first resonant cavity between an input mirror (166, 188) and an intermediate mirror (168), a second material (174) forming a second resonant cavity between the intermediate mirror (168) and an output mirror (189), the optical index of said second material (174) being modulatable by an external disturbance, and laser beam reduction means (188) being located at the input of the first resonant cavity, the assembly of the two cavities and two laser beam reduction means being monolithic.

22. Device according to claim 21, the reduction means being constituted by a concave mirror produced with a micromirror (188) on the face of the active laser medium (182) to be traversed by the microlaser pumping beam (180).

23. Device according to one of the claims 21 or 22, the output mirror (189) being a concave mirror produced with a micromirror on the output face of the second material (174).

24. Device according to claim 20, the active laser medium (192) and two mirrors (194, 198; 196, 200) forming a Fabry-Perot cavity, which is at the optical stability limit, and means (172, 173) are provided for varying the optical length of the cavity so as to pass it from an optically unstable state to an optically stable state.

25. Device according to claim 24, the cavity being a hemispherical, confocal, concentric or spherical cavity.

26. Device according to one of the claims 24 or 25, the cavity incorporating a second material (174) with a variable optical length.

27. Device according to claim 26, the means for varying the optical length of the cavity having means for varying the length of the second material.

28. Device according to claim 26, the material constituting the active laser medium (192) and the second material (174) having a different optical index and the means for varying the optical length of the cavity having means (172, 173) for varying the optical index of the second material.

29. Device according to one of the claims 26 or 28, the second material (174) being an electrooptical material.

**Patentansprüche**

1. Vorrichtung für Infrarotsender, umfassend:

   - ein Halbleiterelement (12, 24, 40, 42, 44, 50, 56, 70), fähig eine Infrarotstrahlung auszusenden,
   - einen gütegeschalteten Mikrolaser (2, 4, 6, 8, 48, 68), so angeordnet, dass er das Halbleiterelement optisch pumpen kann, wobei das Halbleiterelement (12, 24, 40, 42, 44) direkt auf der Austritts- bzw. Auskopplungsfläche des Mikrolasers befestigt ist.

2. Vorrichtung nach Anspruch 1, wobei das Halbleiterelement die Form eines Plättchens mit einer Dicke von einigen hundert Mikrometern hat.

3. Vorrichtung nach Anspruch 1, wobei das Halbleiterelement die Form einer auf einem Substrat mittels Epitaxie abgeschiedenen Schicht hat.

4. Vorrichtung nach einem der Ansprüche 1 bis 3, wobei das Halbleiterelement auf $Pb_xSn_{1-x}Se$ oder $Pb_xSn_{1-x}Te$ oder $PbS_{1-x}Se_x$ oder $InAs_xSb_{1-x}$ oder $Cd_xHg_{1-x}Te$ oder $Cd_xPb_{1-x}S$ oder $Bi_{1-x}Sb_x$ $(0{\leq}x{\leq}1)$ basiert.

5. Vorrichtung nach einem der Ansprüche 1 bis 3, wobei das Halbleiterelement auf $In_xGa_{1-x}As$ oder $InAs_xP_{1-x}$ oder $Cd_xZn_{1-x}S$ oder $(Al_xGa_{1-x})_yIn_{1-y}As$ oder $(Al_xGa_{1-x})_yIn_{1-y}P$ basiert.

6. Vorrichtung nach einem der Ansprüche 1 bis 5, wobei wenigstens eine der Flächen des Halbleiters einer Antireflex-Behandlung unterzogen wird (26, 28).

7. Vorrichtung nach einem der Ansprüche 1 bis 3, wobei das Halbleiterelement (24, 40, 42, 44, 50, 56, 70) Teil eines Halbleiterlasers (34) ist.

8. Vorrichtung nach Anspruch 7, wobei der Halbleiterlaser vom VCSEL-Typ ist.

9. Vorrichtung nach Anspruch 7, wobei der Halbleiterlaser (50, 52, 56, 58) vom Wellenleiter-Typ ist, wobei das Halbleiterelement die Form einer auf einem Substrat (52, 58) abgeschiedenen Schicht (50, 56) hat.

10. Vorrichtung nach Anspruch 9, wobei die Halbleiterschicht (56) entsprechend einer Ebene ausgerichtet ist, die im Wesentlichen senkrecht zu der Richtung des durch den Mikrolaser emittierten Strahls ist.

11. Vorrichtung nach einem der Ansprüche 1 bis 5, dadurch gekennzeichnet, dass der Mikrolaser optische Einrichtungen (123, 129, 189, 200) zur Formung des Mikrolaserstrahls umfasst, wobei eine Ausgangsfläche dieser Einrichtungen die Austritts- bzw. Auskopplungsfläche des Mikrolasers (14) bildet.

12. Vorrichtung nach einem der vorangehenden Ansprüche, wobei optische Einrichtungen (72, 74) zur Formung eines durch das Halbleiterelement (70) abgestrahlten Infrarotbündels am Ausgang dieses Elements vorgesehen sind.

13. Vorrichtung nach einem der vorangehenden Ansprüche, wobei der Mikrolaserresonator stabilisiert ist.

14. Vorrichtung nach einem der vorangehenden Ansprüche, wobei der Mikrolaserresonator passiv gütegeschaltet ist.

15. Vorrichtung nach Anspruch 14, wobei der Mikrolaserresonator ein festes aktives Medium (6) und ein sättigbares Absorptionselement (8) umfasst und dieses letztere durch eine dünne Schicht aus sättigbarem absorbierendem, direkt auf das feste aktive Medium aufgebrachten Materials gebildet wird.

16. Vorrichtung nach Anspruch 15, wobei die dünne Schicht durch einen in einem polymeren Lösungsmittel gelösten organischen Farbstoff gebildet wird.

17. Vorrichtung nach Anspruch 16, wobei der organische Farbstoff zwischen dem Bis(4-diethylaminodithiobenzyl)Nickel und dem Bis(4-dimethylaminodithiobenzyl)Nickel gewählt wird und das Lösungsmittel eine Lösung von Polymethylmetacrylat (PMMA), von Polyvinylalkohol oder von Polyvinylacetat oder von Polystyrol ist.

18. Vorrichtung nach Anspruch 15, wobei die dünne Schicht durch Flüssigphasen-Epitaxie abgeschieden worden sein kann.

19. Vorrichtung nach Anspruch 18, wobei die dünne Schicht durch ein Basismaterial gebildet wird, das mit dem des aktiven Mediums identisch und mit $Cr^{4+}$- oder $Er^{3+}$-Ionen dotiert ist.

20. Vorrichtung nach Anspruch 1 bis 13, wobei der Mikrolaser aktiv gütegeschaltet ist.

21. Vorrichtung nach Anspruch 20, bei der das aktive Lasermedium (162, 182) einen ersten optischen Resonator zwischen einem Eintrittsspiegel (166, 188) und einem Zwischenspiegel (168) bildet und ein zweites Material (174) einen zweiten optischen Resonator zwischen dem Zwischenspiegel (168) und einem Ausgangs- bzw. Auskopplungsspiegel (189) bildet, wobei der optische Index dieses zweiten Materials durch eine äußere Störung moduliert werden kann, Einrichtungen zur Reduzierung der Abmessung des Laserstrahls am Eingang des ersten optischen Resonators angeordnet sind und der Aufbau aus den beiden optischen Resonatoren und den Laserstrahl-Reduziereinrichtungen monolithisch sind.

22. Vorrichtung nach Anspruch 21, wobei die Reduziereinrichtungen durch einen konkaven Spiegel (188) auf der Seite bzw. Fläche des aktiven Lasermediums (182) gebildet werden, wo der Pumpstrahl (180) des Mikrolasers eintritt.

23. Vorrichtung nach einem der Ansprüche 22 oder 23, wobei der Auskopplungsspiegel (189) ein konkaver Spiegel ist, realisiert in Form eines Mikrospiegels an der Austrittsfläche des zweiten Materials (174).

24. Vorrichtung nach Anspruch 20, wobei das aktive Lasermedium (192) und zwei Spiegel (194, 198; 196, 200) einen Fabry-Perot-Resonator bilden, dieser Resonator an der Grenze der optischen Stabilität arbeitet und Einrichtungen (172, 173) vorgesehen sind, die ermöglichen, die optische Länge des Resonators so zu variieren, dass der Resonator aus einem optisch instabilen Zustand in einen optisch stabilen Zustand übergeht.

25. Vorrichtung nach Anspruch 24, wobei der optische Resonator ein hemisphärischer, konfokaler, konzentrischer oder sphärischer Resonator ist.

26. Vorrichtung nach einem der Ansprüche 24 und 25, wobei der optische Resonator ein zweites Material (174) von variabler optischer Länge umfasst.

27. Vorrichtung nach Anspruch 26, wobei die Einrichtungen zum Variieren der optischen Länge des Resonators Mittel umfassen, um die Länge des zweiten Materials zu variieren.

28. Vorrichtung nach Anspruch 26, wobei das das aktive Lasermaterial (192) bildende Material und das zweite Material (174) unterschiedliche optische Indices haben und die Einrichtungen zum Variieren der optischen Länge des Resonators Mittel (172, 173) zum Variieren des optischen Index des zweiten Materials umfassen.

29. Vorrichtung nach einem der Ansprüche 26 oder 28, wobei das zweite Material (174) ein elektroopti-

sches Material ist.

$In_{1-x}Ga_xAs_yP_{1-y}$ ←——→

$GaAs_xSb_{1-x}$ ←——→

$InAs_xP_{1-x}$ ←————————→          $Bi_{1-x}Sb_x$ ←—— —— →

$(Al_xGa_{1-x})_yIn_{1-y}As$ ←——→

$Al_xGa_{1-x}As$ ←→          ←—— —— —— —— —→ $Pb_xSn_{1-x}Se$

$GaAs_{1-x}P_x$ ←→          ←—— —— —— —— —→ $Pb_xSn_{1-x}Te$

$InGa_{1-x}As$ ←————————→     ←—— —→ $PbS_{1-x}Se_x$

$(Al_xGa_{1-x})_yIn_{1-y}P$ ←→     ←—— —→ $InAs_xSb_{1-x}$

$CdS_xSe_{1-x}$ ←→          ←—— —— —— —— —→ $Cd_xHg_{1-x}Te$

$Cd_xZn_{1-x}S$ ←——→     ←—— —— —— —→ $Cd_xPb_{1-x}S$

$\mu m$

|————|————————|————|————————|————|————————|————|
0          0,5          1          5          10          50     100

## FIG. 1

## FIG. 2

FIG. 3

FIG. 4A

FIG. 4B

FIG. 5

FIG. 6

FIG. 7

FIG. 8

FIG. 9

FIG. 10A

146

FIG. 10B

148

146

FIG. 10C

150

148

146

151

FIG. 10D

152

150

148

151

146

FIG. 10E

152

FIG. 11

FIG. 12

FIG. 13

FIG. 14

FIG. 15

FIG. 17

FIG. 16 A

FIG. 16 B